# EUROPEAN PATENT APPLICATION

(11) **EP 4 468 164 A1**
(43) Date of publication of application: **27.11.2024**
(21) Application number: 24175012.4
(22) Date of filing: 09.05.2024
(51) Int. Cl.: G06F 13/40

(54) **MULTIFUNCTION CONTROL APPARATUS**

(30) Priority: 25.05.2023 IT 202300002226 U
(71) Applicant: Energy Technology S.r.l., 40056 Valsamoggia (BO) (IT)
(72) Inventor: RINALDI, LUIGI, 07100 SASSARI (IT); MORICI, RICCARDO, 40013 CASTEL MAGGIORE (BOLOGNA) (IT); CIVALE, MATTEO, 40033 CASALECCHIO DI RENO (BOLOGNA) (IT); MORRI, CRISTIANO, 40128 BOLOGNA (IT); TADDIA, GIUSEPPE, 40066 PIEVE DI CENTO (IT)
(74) Representative: Milli, Simone

(57) **Abstract**

Described is a multifunction control apparatus (1), comprising:
- a main card (2), provided with a first processing unit (3), and a plurality of expansion slots (S1, S2, S3, S4, S5, S6, S7, S8);
- A plurality of accessory cards (SC1, SC2), which can each be inserted in an expansion slot (S1, S2, S3, S4, S5, S6, S7, S8), at least one of said accessory cards (SC1, SC2) being a management card (SC1) of the slave type with respect to the main card (2), said management card (SC1) comprising:
- a second processing unit (4);
- at least one communication interface.

## Description

The invention relates to a multi-function control apparatus, that is to say, which is able to perform a plurality of control functions.

In the sector of electronic devices the need is known of controlling an apparatus by means of a control apparatus which can receive a plurality of input signals, perform processing on them, and return as output control signals.

The aim of the invention is to provide a multifunction control apparatus which is particularly efficient, inexpensive, and which also has compatibility with the control apparatuses which are now obsolete.

Another aim of the invention is to provide a multifunction control apparatus which is very high performing and which is capable of performing innovative functions.

The above-mentioned aims are achieved by a control apparatus according to the invention.

The features of the invention which do not emerge from the above are made clear in the following description, which should be considered with reference to the accompanying drawings, in which:

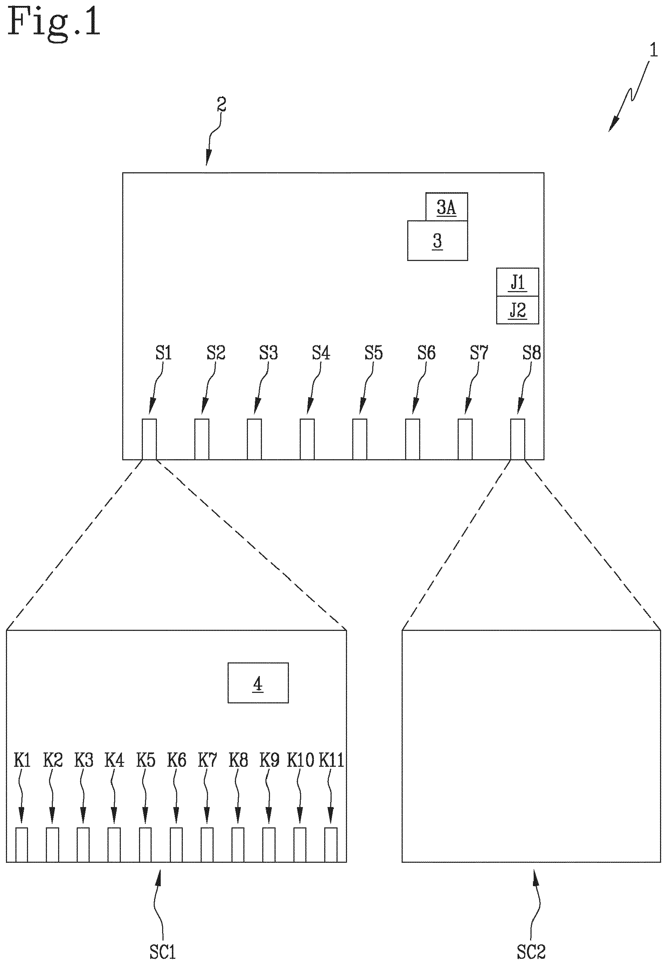

- Figure 1 schematically illustrates a control apparatus according to the invention.

A multifunction control apparatus 1 is described with reference to Figure 1, comprising:
- a main card 2, provided with a first processing unit (3), and a plurality of expansion slots S1, S2, S3, S4, S5, S6, S7, S8;
- a plurality of accessory cards SC1, SC2, which can each be inserted in an expansion slot S1, S2, S3, S4, S5, S6, S7, S8, at least one of said accessory cards SC1, SC2 being a management card SC1 of the slave type with respect to the main card 2, said management card SC1 comprising:
- a second processing unit 4;
- at least one communication interface.

It should be noted that the accessory cards SC1, SC2 may perform a plurality of functions, such as, for example, but without limiting the scope of the invention, Digital/Analogue conversion, Analogue/Digital conversion, acquisition and emission of logic signals according to industrial standards. According to another aspect, the main card 2 comprises at least one input and/or output S3 configured to implement a serial communication standard of the *low voltage differential signalling* type.

Preferably, the main card 2 comprises a plurality of inputs and/or outputs (S1, S2, S3, S4, S5, S6, S7, S8) configured to implement a serial communication standard of the *low voltage differential signalling* type. According to another aspect, the second processing unit 4 comprises at least one FPGA type electronic device.

According to another aspect, the second processing unit 4 comprises at least one RISC type electronic processing device (based on one or more cores).

Preferably, the electronic device of the second processing unit 4 is able to execute a POSIX operating system (standard).

According to yet another aspect, the management card SC1 comprises a plurality of inputs and/or outputs (K1,K2,K3,K4,K5,K6,K7,K8,K9,K10,K11). According to another aspect, the management card SC1 comprises at least one input and/or output configured to implement an optical fibre communication.

According to another aspect, the management card SC1 comprises at least one input and/or output configured to implement an electrical cable communication.

According to yet another aspect, the management card SC1 comprises at least one Ethernet type input and/or output.

According to yet another aspect, the management card SC1 comprises at least one input K2 for a timer.

According to yet another aspect, the input K2 for the timer comprises an optical fibre interface.

According to yet another aspect, the management card SC1 comprises at least one input and output K3 configured to implement an HMI type interface.

According to yet another aspect, the above-mentioned input and output K3 configured to implement an HMI type interface comprises an Ethernet interface.

According to yet another aspect, the management card SC1 comprises at least one high speed control input and/or output K4, configured for releasing or receiving control signals.

According to yet another aspect, the above-mentioned at least one high speed control input and/or output K4 comprises an optical fibre interface.

According to yet another aspect, said above-mentioned at least one high speed control input and/or output K4 has a speed greater than 100 Mbit/s. According to yet another aspect, the management card SC1 comprises at least one fast monitoring control output K5.

According to yet another aspect, the fast monitoring control output K5 comprises an Ethernet type interface.

According to yet another aspect, the management card SC1 comprises a rapid control output and/or input K6.

According to yet another aspect, the above-mentioned rapid control output and/or input K6 comprises an Ethernet type interface.

According to another aspect, the Ethernet type interface of the output and/or input K6 has a speed greater than 1000 Mbit/s.

It should also be noted that, according to other aspects, the management card SC1 comprises a rapid monitoring output and/or input K7.

Preferably, the above-mentioned rapid monitoring output and/or input K7 comprises an Ethernet type interface.

According to another aspect, the Ethernet type interface of the above-mentioned rapid monitoring output and/or input (K7) has a speed greater than 1000 Mbit/s.

According to another aspect, the main card 2 comprises an interlock output and/or input J1, provided with/or a plurality of contacts and wherein the first processing unit 3 is configured for setting up or detecting the status of said contacts.

According to yet another aspect, the management card SC1 comprises a slow monitoring output K9, with said slow monitoring output having a speed of less than 100 Mbit/s.

Preferably, the above-mentioned slow monitoring output K9 comprises an Ethernet type interface.

According to another aspect, the management card SC1 comprises a slow control output and/or input K10, with said slow control output and/or input K10 having a speed of less than 100 Mbit/s.

According to yet another aspect, the above-mentioned slow control output and/or input K10 comprises an Ethernet type interface.

According to another aspect, the main card 2 comprises a locking output and/or input J2, configured for transmitting a train of pulses or to remain in a predetermined logic state.

According to another aspect, the above-mentioned locking output and/or input J2 comprises an optical fibre interface.

Preferably, the above-mentioned locking output and/or input J2 is configured to receive trains, that is to say, sequences of pulses. According to yet another aspect, the main card 2 is configured for allowing a firmware of the first processing unit 3 to be updated.

According to another aspect, the first processing unit 3 is provided with a thermal dissipation unit 3A.

Preferably, the thermal dissipation unit 3A is configured for adapting, that is to say, adjusting, the quantity of cooling thermal power (that is, exchanged with the first processing unit 3).

In particular, the above-mentioned cooling thermal power may be adjustable on the basis of the work load, that is to say, the processing speed of the first processing unit 3.

According to yet another aspect, the main card 2 is configured to allow a firmware of the first processing unit 3 for processing using the control card SC1 to be updated.

According to another aspect, the main card 2 is configured for allowing a firmware of the first processing unit 3 using an Ethernet interface to be updated.

It should be noted that, advantageously, the control apparatus 1 is applicable to a plurality of systems and is extremely flexible.

In fact, thanks to the presence of numerous slots which are each able to receive a dedicated expansion card, it is possible to configure the control apparatus 1 in such a way as to receive a plurality of cards designed to perform a wide range of functions.

It should be noted that the control apparatus 1 is preferably housed inside a container (not illustrated).

Preferably, the mechanical dimensions of the main card 2 and of the accessory cards (SC1, SC2) are mechanically compatible with the containers already present on the market; this means that a retrofitting is also possible of existing control apparatuses, in a plurality of systems controlled by them.

It should be noted that, in particular, the mechanical dimensions of the main card 2 and of the accessory cards (SC1, SC2) are mechanically compatible with the "19 inch rack" format.

According to another aspect, the control apparatus 1 may comprise an operating system, for example LINUX, installed on the second processing unit 4.

It should be noted that the second processing unit 4 may comprise one or more processors.

Preferably, the management card SC1 also comprises one or more RAM memory banks.

According to another aspect, the main card 2 is provided with a suitable inlet for the power supply.

## Claims

1. A multifunction control apparatus (1), comprising:
- a main card (2), provided with a first processing unit (3), and a plurality of expansion slots (S1, S2, S3, S4, S5, S6, S7, S8);
- a plurality of accessory cards (SC1, SC2), which can each be inserted in an expansion slot (S1, S2, S3, S4, S5, S6, S7, S8), at least one of said accessory cards (SC1, SC2) being a management card (SC1) of the slave type with respect to the main card (2), said management card (SC1) comprising:
- a second processing unit (4);
- at least one communication interface.

2. The multifunction control apparatus according to the preceding claim, wherein the second processing unit (4) comprises at least one FPGA type electronic device.

3. The multifunction control apparatus according to any one of the preceding claims, wherein the second processing unit (4) comprises at least one ARM type electronic device.

4. The multifunction control apparatus according to any one of the preceding claims, wherein the main card (2) comprises at least one input and/or output (S3) configured to implement a serial communication standard of the *low voltage differential signalling* type.

5. The multifunction control apparatus according to any one of the preceding claims, wherein the management card (SC1) comprises at least one input and/or output configured to implement an optical fibre communication.

6. The multifunction control apparatus according to any one of the preceding claims, wherein the management card (SC1) comprises at least one input and/or output configured to implement an electrical cable communication.

7. The multifunction control apparatus according to any one of the preceding claims, wherein the management card (SC1) comprises at least one Ethernet type input and/or output.

8. The multifunction control apparatus according to any one of the preceding claims, wherein the management card (SC1) comprises at least one input (K2) for a timer.

9. The multifunction control apparatus according to the preceding claim, wherein the input (K2) for the timer comprises an optical fibre interface.

10. The multifunction control apparatus according to any one of the preceding claims, wherein the management card (SC1) comprises at least one input and output (K3) configured to implement an HMI type interface.

11. The multifunction control apparatus according to the preceding claim, wherein the above-mentioned input and output (K3) configured for implementing an HMI type interface comprises an Ethernet interface.

12. The multifunction control apparatus according to any one of the preceding claims, wherein the management card (SC1) comprises at least one high speed control input and/or output (K4), configured for releasing or receiving control signals.

13. The multifunction control apparatus according to the preceding claim, wherein the above-mentioned at least one high speed control input and/or output (K4) comprises an optical fibre interface.

14. The multifunction control apparatus according to claim 11 or 12, wherein said above-mentioned at least one high speed control input and/or output (K4) has a speed greater than 100 Mbit/s.

15. The multifunction control apparatus according to any one of the preceding claims, wherein the management card (SC1) comprises at least one fast monitoring control output (K5).
